# EUROPEAN PATENT SPECIFICATION

(11) **EP 4 403 909 B1**
(45) Date of publication and mention of the grant of the patent: **25.03.2026**
(21) Application number: 21965038.9
(22) Date of filing: 23.11.2021
(51) Int. Cl.: G01N 23/225, G01N 1/28, H01L 21/67

(54) **ELECTRON BEAM INSPECTION EQUIPMENT AND INSPECTION METHOD**
ELEKTRONENSTRAHLINSPEKTIONSGERÄT UND INSPEKTIONSVERFAHREN
ÉQUIPEMENT D'INSPECTION À FAISCEAU D'ÉLECTRONS ET PROCÉDÉ D'INSPECTION

(43) Date of publication of application: 24.07.2024
(73) Proprietor: Huawei Technologies Co., Ltd., Shenzhen, Guangdong 518129 (CN)
(72) Inventor: ZENG, Jie, Shenzhen, Guangdong 518129 (CN); XIN, Guizhen, Shenzhen, Guangdong 518129 (CN); SHI, Xiaoshan, Shenzhen, Guangdong 518129 (CN); WANG, Yang, Shenzhen, Guangdong 518129 (CN); HAO, Yanzhong, Shenzhen, Guangdong 518129 (CN); LIU, Qitao, Shenzhen, Guangdong 518129 (CN); GUAN, Taotao, Shenzhen, Guangdong 518129 (CN)
(74) Representative: Epping - Hermann - Fischer
(86) International application number: PCT/CN2021/132505
(87) International publication number: WO 2023/092298

(56) References cited:
- CN-A- 101 988 911
- CN-A- 110 926 898
- CN-A- 111 595 880
- JP-A- 2010 197 269
- JP-A- 2011 034 895
- JP-A- H01 107 446
- JP-A- H11 311 611
- JP-A- H11 311 611
- US-A- 5 976 328

## Description

### TECHNICAL FIELD

This application relates to the field of semiconductor technologies, and in particular, to an electron beam inspection device and an inspection method.

### BACKGROUND

A semiconductor inspection device is mainly configured to inspect performance and a defect of a wafer (wafer) or mask (mask) in a semiconductor manufacturing process, and inspection is performed throughout the semiconductor production process. In a broad sense, the semiconductor inspection device is divided into a front-end-of-line testing device and a back-end-of-line testing device based on testing phases. An electron beam inspection device for front-end-of-line inspection may include a scanning electron microscope, a transmission electron microscope, an electron beam inspection (Electrons Beam inspection, E-beam inspection for short, EBI) device, and the like. The electron beam inspection device is configured to emit an electron beam to inspect a physical defect of a semiconductor wafer or mask, and the physical defect may include a particle, an impurity, a crack, or the like on the semiconductor wafer or mask. The electron beam inspection device uses the following inspection manner: scanning a to-be-inspected wafer or mask by using an electron beam, to obtain an image of secondary electron imaging; and performing comparison and recognition by using computer vision, to find an abnormal dot in the image and use the abnormal dot as a defect.

However, when the electron beam inspection device performs inspection by using an electron beam, charged effect is often generated on a surface of a to-be-inspected product with poor conductivity. This affects an inspection result. The charged effect means that when the electron beam is irradiated on the surface of the to-be-inspected product, excess charges cannot be conducted away in time, and charge accumulation is formed on the surface of the to-be-inspected product. Therefore, an electrostatic field is generated and interferes with electron beam incidence and secondary electron emission. In addition, due to impact of the charged effect, in a subsequent testing process of the scanning electron microscope, a scanned image of the to-be-inspected product may be blurred due to the charged effect on the surface of the to-be-inspected product. This affects an observation result of the to-be-inspected product.

To alleviate the impact of the charged effect, in the conventional technology, a conductive film with relatively good conductivity, such as a gold film or a platinum film, may be sputtered on the surface of the to-be-inspected product, to change a conductive property of the surface of the to-be-inspected product, so that accumulated charges can flow out through a sample stage. However, in the method, after the to-be-inspected product is inspected, the conductive film further needs to be cleaned. However, it is difficult to completely clean the conductive film on the surface of the to-be-inspected product by using a process in the conventional technology. This causes contamination to the to-be-inspected product. In addition, it is difficult to control a thickness of the sputtered conductive film in this method. If the sputtered conductive film is too thick, original morphology of the surface of the sample may be covered, and specific impact may be caused for sample composition analysis.

Therefore, how to avoid charged effect caused by the electron beam device on a surface of a to-be-inspected product in an inspection process is a problem that needs to be urgently resolved.

The following document is mentioned as being a pertinent prior art illustration:
JP H11311611A discloses an electronic spectroscopic analysis method used in semiconductor device manufacture.

The following documents are also mentioned as a complementary prior art illustration:
US 5976328A
JP 2011034895A

### SUMMARY

Embodiments of this application provide an electron beam inspection device and an inspection method, to avoid charged effect caused by the electron beam inspection device on a surface of a to-be-inspected product in an inspection process.

According to a first aspect, an embodiment of this application provides an electron beam inspection device. The device includes a first processing cavity and a second processing cavity. The first processing cavity is configured to form a carbon film on a surface of a substrate in a physical vapor deposition manner. The second processing cavity is configured to perform electron beam scanning on the substrate with the surface on which the carbon film is deposited, and is further configured to clean the carbon film on the surface of the scanned substrate through oxygen plasma.

In the device provided in the first aspect, the electron beam inspection device includes two processing cavities that are independent of each other: the first processing cavity and the second processing cavity. The first processing cavity is configured to deposit a uniform ultrathin cleanable carbon film on the surface of the substrate (a to-be-inspected semiconductor product, namely, a wafer or mask) in the first processing cavity. Because of good conductivity, the carbon film can conduct away charges accumulated on the surface of the substrate during electron beam inspection, to alleviate charged effect in an electron beam inspection process. In addition, the ultrathin carbon film deposited in the first processing cavity may reach a thickness less than 10 nm, thereby avoiding a problem that an inspection result is usually interfered with by an excessively thick conductive film. The second processing cavity in the electron beam inspection device is configured to perform electron beam scanning on the substrate on which the ultrathin carbon film is deposited, to find a physical defect of the substrate. After completing the scanning, the second processing cavity may further clean the ultrathin carbon film on the surface of the substrate through the oxygen plasma. Because oxygen and carbon can undergo a combustion reaction (O₂+C=CO₂), the oxygen plasma can react with the carbon film on the surface of the substrate to generate carbon dioxide gas, to clean the carbon film on the surface of the substrate, thereby avoiding a problem that a to-be-inspected product is contaminated due to incomplete cleaning of an existing conductive film. In addition, in the second processing cavity, an oxygen plasma amount may be controlled to be far greater than a carbon film amount. Therefore, the carbon film can be completely cleaned (100% cleaned), so that the carbon film does not have any residue on the surface of the substrate. In addition, the oxygen plasma almost does not react with a manufacturing material of the substrate (the wafer or mask). Therefore, on a premise that the carbon film is completely cleaned, the oxygen plasma can further ensure that the substrate is not affected. In conclusion, because the electron beam inspection device includes the two processing cavities that are independent of each other, carbon film deposition, electron beam inspection, and complete carbon film cleaning can be separately implemented, thereby successfully avoiding charged effect caused by the electron beam inspection device on the surface of the to-be-inspected product in the inspection process, avoiding a problem that the substrate is contaminated by a conductive film and a problem that an inspection result is interfered with by the conductive film, and improving efficiency of performing electron beam inspection on the substrate.

In a possible implementation, a thickness of the carbon film is less than 10 nm.

In this embodiment of this application, the ultrathin carbon film does not cover original morphology of the surface of the substrate, and further greatly alleviates interference caused for the substrate in the subsequent electron beam inspection process, thereby avoiding impact on substrate composition analysis.

In a possible implementation, the second processing cavity is further configured to: before forming the carbon film on the surface of the substrate, clean an organic film on the surface of the substrate through oxygen plasma.

In this embodiment of this application, when the substrate (for example, the wafer or mask) is produced at a normal temperature and pressure, the substrate may be often exposed to air due to a production process. Therefore, an organic film is extremely prone to be formed on the surface of the substrate. This causes contamination to the substrate and also affects an electron beam inspection result. Therefore, before carbon film deposition, the organic film is cleaned by using, for example, an oxygen plasma technology, thereby helping improve purity of carbon film deposition, and avoiding impact of the organic film on the electron beam inspection result.

In a possible implementation, the device further includes a first moving apparatus, and the first moving apparatus is configured to transfer the substrate between the first processing cavity and the second processing cavity.

In this embodiment of this application, the first moving apparatus may include a vacuum cavity, and the first moving apparatus may keep transferring the substrate between the first processing cavity and the second processing cavity in a vacuum environment. Therefore, the electron beam inspection device is applicable to a large-scale semiconductor manufacturing process, to form a pipeline operation, and help improve a production capacity of the semiconductor industry.

In a possible implementation, the device further includes a second moving apparatus, and the second moving apparatus is configured to transfer the substrate at a normal temperature and pressure to the second processing cavity.

In this embodiment of this application, the second moving apparatus may be understood as a robot hand, a robot arm, or the like. To be specific, the second moving apparatus may transfer the substrate from the normal temperature and pressure to a vacuum cavity (for example, the second processing cavity). For example, the second moving apparatus may transfer the substrate to the second processing cavity in which the organic film is first cleaned, to alleviate a problem that the inspection result is interfered with by the organic film.

In a possible implementation, the second processing cavity includes an electron beam inspection cavity, and the electron beam inspection cavity is configured to perform electron beam scanning on the substrate with the surface on which the carbon film is deposited.

In this embodiment of this application, the electron beam inspection cavity is an independent cavity in the second processing cavity, and can separate the electron beam inspection process from a carbon film cleaning process, so that all processes do not interfere with each other and are orderly, thereby improving efficiency of performing electron beam inspection on the substrate.

In a possible implementation, the second processing cavity further includes a plasma processing cavity, and the plasma processing cavity is configured to clean the carbon film on the surface of the scanned substrate through the oxygen plasma.

In this embodiment of this application, the plasma processing cavity is also used as an independent cavity in the second processing cavity, and can separate the electron beam inspection process from the carbon film cleaning process, so that all the processes do not interfere with each other and are orderly, thereby improving efficiency of performing electron beam inspection on the substrate.

In a possible implementation, the plasma processing cavity is further configured to: before forming the carbon film on the surface of the substrate, clean the organic film on the surface of the substrate through the oxygen plasma.

In this embodiment of this application, before carbon film deposition, the organic film is cleaned by using, for example, an oxygen plasma technology, thereby helping improve purity of carbon film deposition, and avoiding impact of the organic film on the electron beam inspection result.

In a possible implementation, the first moving apparatus is further configured to transfer the substrate from the plasma processing cavity to the first processing cavity, from the first processing cavity to the electron beam inspection cavity, or from the electron beam inspection cavity to the plasma processing cavity.

In this embodiment of this application, the first moving apparatus may keep transferring the substrate between the plasma processing cavity, the first processing cavity, and the electron beam inspection cavity in a fixed direction in a vacuum environment. In addition, when the second processing cavity includes the electron beam inspection cavity and the plasma processing cavity, the first moving apparatus can transfer the substrate along a fixed route without mutual interference, so that the electron beam inspection device is applicable to a large-scale semiconductor manufacturing process, to form a pipeline operation, and help improve a production capacity of the semiconductor industry.

In a possible implementation, the second moving apparatus is further configured to transfer the substrate at the normal temperature and pressure to the plasma processing cavity.

In this embodiment of this application, the second moving apparatus may be understood as a robot hand, a robot arm, or the like. To be specific, the second moving apparatus may transfer the substrate from the normal temperature and pressure to a vacuum cavity (for example, the plasma processing cavity). The second moving apparatus may transfer the substrate to the plasma processing cavity, so that the plasma processing cavity cleans the organic film on the surface of the substrate, to alleviate a problem that the inspection result is interfered with by the organic film. In a possible implementation, the electron beam inspection device further includes the second moving apparatus, and the second moving apparatus is configured to transfer the substrate in the second processing cavity to the normal temperature and pressure, or the second moving apparatus is configured to transfer the substrate in the plasma processing cavity to the normal temperature and pressure.

In this embodiment of this application, the second moving apparatus may be understood as a robot hand, a robot arm, or the like. Due to a limitation of a process, the second moving apparatus may further transfer the substrate from a vacuum cavity (for example, the second processing cavity or the plasma processing cavity) to the normal temperature and pressure, to perform a next manufacturing process.

In a possible implementation, the device further includes a vacuum pump, and the vacuum pump is configured to exhaust gas from the second processing cavity after the carbon film on the surface of the scanned substrate is cleaned through the oxygen plasma.

In this embodiment of this application, after the carbon film deposited on the surface of the scanned substrate is cleaned, the vacuum pump can exhaust carbon dioxide gas, namely, a product of a reaction between the oxygen plasma and the carbon film, from the cavity in time, thereby avoiding a problem that the to-be-inspected product is contaminated.

In a possible implementation, both the first processing cavity and the second processing cavity are closeable vacuum cavities, and the first moving apparatus includes a closeable vacuum cavity.

In this embodiment of this application, a vacuum environment is kept in substrate transfer, carbon film deposition, electron beam inspection, and carbon film cleaning processes, to help improve quality of the deposited carbon film, and greatly reduce a problem that the to-be-inspected product is contaminated by the carbon film and a problem that the inspection result is interfered with by the carbon film in a non-vacuum environment.

According to a second aspect, an embodiment of this application provides an inspection method, applied to an electron beam inspection device. The electron beam inspection device includes a first processing cavity and a second processing cavity. The method includes: forming a carbon film on a surface of a substrate in a physical vapor deposition manner in the first processing cavity; performing, in the second processing cavity, electron beam scanning on the substrate with the surface on which the carbon film is deposited; and cleaning the carbon film on the surface of the scanned substrate through oxygen plasma in the second processing cavity.

In a possible implementation, a thickness of the carbon film is less than 10 nm.

In a possible implementation, the forming a carbon film on a surface of a substrate in a physical vapor deposition manner in the first processing cavity includes: when the first processing cavity is in a first vacuum environment, forming the carbon film on the surface of the substrate in the physical vapor deposition manner, where a vacuum degree of the first vacuum environment is 1×10⁻³ Pa to 1×10⁻⁹ Pa, a voltage of the first processing cavity is 200 V to 8 kV, and deposition time of the first processing cavity is 10s to 600s.

In a possible implementation, the performing, in the second processing cavity, electron beam scanning on the substrate with the surface on which the carbon film is deposited includes: when the second processing cavity is in a second vacuum environment, performing electron beam scanning on the substrate with the surface on which the carbon film is deposited, where a vacuum degree of the second vacuum environment is 1×10⁻⁸ Pa to 1×10⁻⁹ Pa, a voltage of the second processing cavity is 20 kV to 80 kV, and scanning time of the second processing cavity is 360s to 1800s; and the cleaning, through oxygen plasma in the second processing cavity, the carbon film deposited on the surface of the scanned substrate includes: when the second processing cavity is in a third vacuum environment, cleaning, through the oxygen plasma, the carbon film deposited on the surface of the scanned substrate, where a vacuum degree of the third vacuum environment is 1×10⁻³ Pa to 1×10⁻⁷ Pa, a voltage of the second processing cavity is 200 V to 8 kV, and cleaning time of the second processing cavity is 10s to 600s.

In a possible implementation, before the forming a carbon film on a surface of a substrate in a physical vapor deposition manner in the first processing cavity, the method further includes:
cleaning an organic film on the surface of the substrate through oxygen plasma in the second processing cavity.

In a possible implementation, the electron beam inspection device further includes a first moving apparatus, and the method further includes: transferring the substrate between the first processing cavity and the second processing cavity through the first moving apparatus.

In a possible implementation, the electron beam inspection device further includes a second moving apparatus, and the method further includes: transferring the substrate at a normal temperature and pressure to the second processing cavity through the second moving apparatus.

In a possible implementation, the second processing cavity includes an electron beam inspection cavity, and the performing, in the second processing cavity, electron beam scanning on the substrate with the surface on which the carbon film is deposited includes: performing, in the electron beam inspection cavity, electron beam scanning on the substrate with the surface on which the carbon film is deposited.

In a possible implementation, the second processing cavity further includes a plasma processing cavity, and the cleaning the carbon film on the surface of the scanned substrate through oxygen plasma in the second processing cavity includes: cleaning the carbon film on the surface of the scanned substrate through the oxygen plasma in the plasma processing cavity.

In a possible implementation, before the forming a carbon film on a surface of a substrate in a physical vapor deposition manner in the first processing cavity, the method further includes: cleaning the organic film on the surface of the substrate through the oxygen plasma in the plasma processing cavity.

In a possible implementation, the transferring the substrate between the first processing cavity and the second processing cavity through the first moving apparatus includes: transferring the substrate from the plasma processing cavity to the first processing cavity, from the first processing cavity to the electron beam inspection cavity, or from the electron beam inspection cavity to the plasma processing cavity through the first moving apparatus.

In a possible implementation, the transferring the substrate at a normal temperature and pressure to the second processing cavity through the second moving apparatus includes: transferring the substrate at the normal temperature and pressure to the plasma processing cavity through the second moving apparatus.

In a possible implementation, the method further includes: transferring the substrate in the second processing cavity to the normal temperature and pressure through the second moving apparatus; or transferring the substrate in the plasma processing cavity to the normal temperature and pressure through the second moving apparatus.

In a possible implementation, the electron beam inspection device further includes a vacuum pump; and after the cleaning, through oxygen plasma in the second processing cavity, the carbon film deposited on the surface of the scanned substrate, the method further includes: exhausting gas from the second processing cavity through the vacuum pump.

### BRIEF DESCRIPTION OF DRAWINGS

To describe the technical solutions in embodiments of this application or in the background more clearly, the following describes the accompanying drawings for describing embodiments of this application or the background.
FIG. 1 is a diagram of a structure of an electron beam inspection device according to an embodiment of this application;
FIG. 2 is a diagram of a structure of another electron beam inspection device according to an embodiment of this application;
FIG. 3 is a diagram of a process based on the electron beam inspection device shown in FIG. 2 according to an embodiment of this application;
FIG. 4 is a diagram of a substrate structure existing before carbon film deposition and a substrate structure obtained after the carbon film deposition according to an embodiment of this application; and
FIG. 5 is a flowchart of steps of an inspection method according to an embodiment of this application.

### DESCRIPTION OF EMBODIMENTS

The following describes embodiments of this application with reference to the accompanying drawings in embodiments of this application.

In the specification, claims, and accompanying drawings of this application, the terms "first", "second", and the like are intended to distinguish between different objects but do not indicate a particular order. In addition, the terms "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the system, the product, or the device.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate a, b, c, "a and b", "a and c", "b and c", or "a, b, and c", where a, b, and c may be singular or plural.

"An embodiment" mentioned in the specification indicates that a particular characteristic, structure, or feature described with reference to this embodiment may be included in at least one embodiment of this application. The phrase shown in various positions in the specification may not necessarily refer to a same embodiment, and is not an independent or optional embodiment exclusive from another embodiment. It is explicitly and implicitly understood by persons skilled in the art that embodiments described in the specification may be combined with another embodiment.

First, for ease of understanding embodiments of this application, the following specifically analyzes a technical problem that needs to be resolved in embodiments of this application and an application scenario.

A semiconductor inspection device is mainly configured to inspect performance and a defect of a semiconductor product (for example, a wafer or mask) in a semiconductor manufacturing process. Inspection needs to be performed after almost every major process is completed, and is performed throughout the semiconductor production process. In a broad sense, the semiconductor inspection device is divided into a front-end-of-line testing device and a back-end-of-line testing device based on testing phases. The front-end-of-line testing device is applicable to front-end-of-line testing. The front-end-of-line testing is applied to a processing and manufacturing process of a semiconductor product. The testing is physical and functional testing, and is used to inspect whether processing parameters of the product meet design requirements after each process, and inspect whether a defect that affects a yield exists on a surface of the semiconductor product, to ensure that a yield of a processing line is controlled to be above a specified level. The back-end-of-line testing device is applicable to back-end-of-line testing. The back-end-of-line testing is mainly applied to an integrated circuit (integrated circuit, IC) packaging phase after semiconductor product processing. The testing is electrical and functional testing, and is used to inspect whether the semiconductor product reaches a performance requirement.

Front-end-of-line metrology and inspection may be subdivided into metrology and inspection based on testing purposes. The metrology is mainly measuring manufacturing dimensions such as a film thickness, a key dimension, and registration accuracy and material properties such as film stress and a doping concentration of a semiconductor product, to ensure that these parameters meet parameter design requirements. The inspection is mainly used to identify and locate an impurity particle, a stain, a mechanical scratch, a wafer pattern defect, or the like on a surface of the semiconductor product. An electron beam inspection device for front-end-of-line inspection may include a scanning electron microscope, a transmission electron microscope, an electron beam inspection (Electrons Beam inspection, E-beam inspection for short, EBI) device, and the like. The electron beam inspection device is configured to emit an electron beam to inspect a physical defect of a semiconductor product, and usually includes one processing cavity. In addition, the physical defect may include, for example, a particle, an impurity, or a crack on a wafer or mask. The electron beam inspection device uses the following inspection manner: scanning a to-be-inspected wafer or mask by using an electron beam, to obtain an image of secondary electron imaging; and performing comparison and recognition by using computer vision, to find an abnormal dot in the image and use the abnormal dot as a defect.

However, when the electron beam inspection device performs inspection by using an electron beam, charged effect is often generated on a surface of a to-be-inspected semiconductor product (for example, an inspected wafer or mask). This affects an inspection result. The charged effect mainly occurs in observation of a to-be-inspected product that is non-conductive, poorly conductive, or poorly grounded. When the electron beam is irradiated on the surface of the to-be-inspected product, excess charges cannot be conducted away in time, and charge accumulation is formed on the surface of the to-be-inspected product. Therefore, an electrostatic field is generated and interferes with electron beam incidence and secondary electron emission. This affects an observation result. For example, the charged effect may have the following several impacts on the observation result:
1. Abnormal contrast: Secondary electron emission is affected by irregular charge accumulation. As a result, a finally received observation image is partially abnormally bright and partially becomes dark.
2. Image distortion: Due to effect of the electrostatic field generated by the charges, the incident electron beam is irregularly deflected in an irradiation process, resulting in image distortion or a phase difference.
3. Image drift: Due to the effect of the electrostatic field, the incident electron beam deflects to a specific direction, resulting in image drift.
4. Bright dot and bright line: Due to irregularity of charge accumulation, irregular discharge often occurs in a charged sample, resulting in irregular bright dots and bright lines in the image.
5. The image is "very flat" and has no three-dimensional sense: Usually, a reason for this phenomenon is that a scanning speed is relatively slow and each pixel has relatively long residence time, causing charge accumulation. The image looks very flat and completely loses the three-dimensional sense.

Therefore, due to impact of the charged effect, in a subsequent testing process of the scanning electron microscope, a scanned image of the to-be-inspected product may be blurred due to the charged effect on the surface of the to-be-inspected product. This affects an observation result of the to-be-inspected product.

Currently, to alleviate the impact of the charged effect and to be applicable to a large-scale production application scenario such as the semiconductor manufacturing industry, in the conventional technology, a conductive film with relatively good conductivity, such as a gold film or a platinum film, may be sputtered on the surface of the to-be-inspected product, to change a conductive property of the surface of the to-be-inspected product, so that accumulated charges can flow out through a sample stage. This is a most common method for alleviating the charged effect. However, the method has the following two defects: a problem that an inspection result is interfered with by the conductive film and a problem that the to-be-inspected product is contaminated by the conductive film.

The problem that the inspection result is interfered with by the conductive film:
(1) Film thickness
   If the conductive film is too thick, original morphology of the surface of the sample may be covered, and specific impact may be caused for sample composition analysis. A film prepared by using a vacuum sputtering coating method currently used in a laboratory is too thick. In addition, the film causes noise for an electron inspection signal. When a noise reduction function of the device is insufficient to compensate for a thickness of the film, both repeatability and accuracy of an inspection result are affected.
(2) Film surface defect

A defect of a large size (10 nm to 10 µm), including a particle, a crack, a groove, or the like, may be inspected on a surface of the coated film in the current technology. A nano-sized defect can be ignored in the laboratory. However, in a semiconductor manufacturing process, any defect greater than 10 nm may cause product scrapping, to reduce an overall yield.

The problem that the to-be-inspected product is contaminated by the conductive film:
After the product is coated and electron inspection is completed, the conductive film (including the gold film or the platinum film) remains on the surface of the to-be-inspected product, causing contamination to the to-be-inspected product. Therefore, the conductive film may be further considered as a destructive inspection method. This affects downstream processing of the product. According to an industry practice of a semiconductor manufacturing process, a product that does not comply with a standard is not allowed to enter a downstream production line. Therefore, after electron inspection is completed, the film needs to be completely cleaned and no defect, including a particle, an impurity residue, a crack, or the like, can be left on the surface of the to-be-inspected product.

Therefore, the conductive film prepared in the current film coating technology can be used in large-scale production only after the foregoing two major technical problems are resolved.

Therefore, to resolve a problem that an inspection result is interfered with by a conductive film and a problem that a product is contaminated by the conductive film, embodiments of this application provide an electron beam inspection device. The electron beam inspection device includes two processing cavities that are independent of each other: a first processing cavity and a second processing cavity. The first processing cavity is configured to deposit an ultrathin cleanable carbon film on a surface of a substrate (a to-be-inspected semiconductor product, namely, a wafer or mask) in the cavity. Because of good conductivity, the carbon film can conduct away charges accumulated on the surface of the substrate during electron beam inspection, to alleviate charged effect in an electron beam inspection process. In addition, the ultrathin carbon film deposited in the first processing cavity may reach a thickness less than 10 nm, thereby avoiding a problem that an inspection result is usually interfered with by an excessively thick conductive film. In addition, the second processing cavity in the electron beam inspection device is configured to perform electron beam scanning on the substrate on which the ultrathin carbon film is deposited, to find a physical defect of the substrate. After completing the scanning, the second processing cavity may be further configured to clean the ultrathin carbon film on the surface of the substrate through oxygen plasma. Because oxygen and carbon can undergo a combustion reaction (O₂+C=CO₂), the oxygen plasma can react with the carbon film on the surface of the substrate to generate carbon dioxide gas, to completely clean the carbon film on the surface of the substrate. In addition, the oxygen plasma almost does not react with a manufacturing material of the substrate (the wafer or mask). Therefore, on a premise that the carbon film is completely cleaned, the oxygen plasma can ensure that the substrate is not affected, thereby avoiding a problem that a to-be-inspected product is contaminated by an existing conductive film.

In addition, the electron beam inspection device and the inspection method provided in embodiments of this application may be implemented to produce various semiconductor products in a large scale and be applied to inspection processes of various semiconductor products, and in particular, alleviate a phenomenon of accumulation of a large amount of charges during electron beam inspection, and further avoid the problem that the to-be-inspected product is contaminated by the conductive film and the problem that the inspection result is interfered with by the conductive film. For example, a uniform carbon film is deposited on the to-be-inspected product. For a specific implementation, correspondingly refer to the following embodiments. Details are not described herein in embodiments of this application.

Based on the foregoing technical problems, to facilitate understanding of embodiments of this application, the following first describes several of electron beam inspection devices on which embodiments of this application are based.

An embodiment of this application provides an electron beam inspection device. The electron beam inspection device includes a first processing cavity and a second processing cavity.

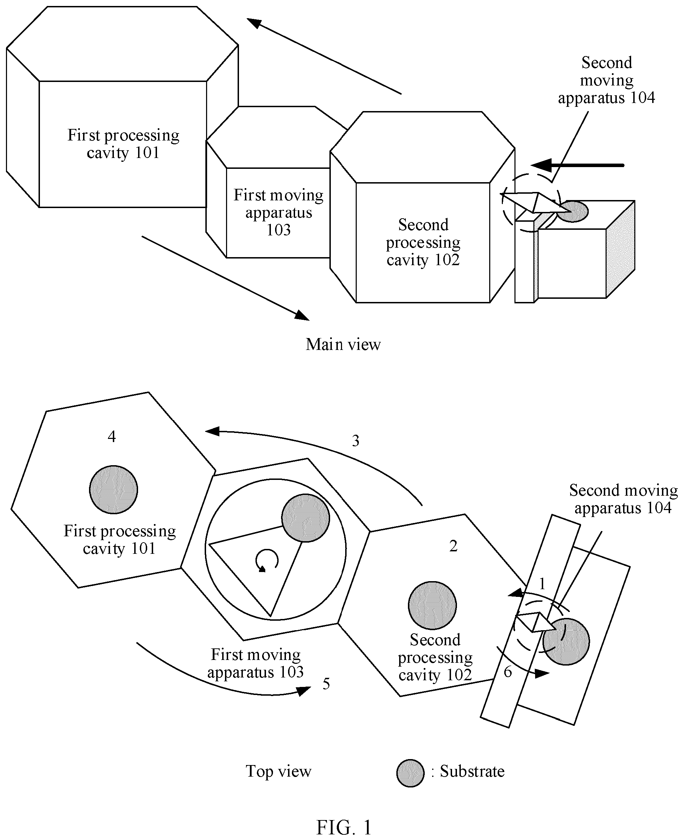

FIG. 1 is a diagram of a structure of an electron beam inspection device according to an embodiment of this application. As shown in a main view in FIG. 1, the electron beam inspection device may include a first processing cavity 101 and a second processing cavity 102. The electron beam inspection device may further include a first moving apparatus 103, a second moving apparatus 104, and a vacuum pump (not shown in the figure). As shown in a top view in FIG. 1, the following operations are performed:
1. Transfer a substrate (a to-be-inspected semiconductor product, for example, a wafer or mask) from a substrate placing platform to the second processing cavity 102 through the second moving apparatus.
2. Clean an organic film on a surface of the substrate through plasma processing in the second processing cavity.
3. After the organic film on the surface of the substrate is cleaned, transfer the substrate from the second processing cavity 102 to the first processing cavity 101 through the first moving apparatus 103.
4. Then, form a carbon film on the surface of the substrate by using a physical vapor deposition technology in the first processing cavity.
5. Then, transfer, from the first processing cavity 101 to the second processing cavity 102 through the first moving apparatus 103, the substrate on which the carbon film is deposited, so that electron beam inspection is performed, in the second processing cavity, on the substrate on which the carbon film is deposited, to obtain a defect inspection result of the substrate.
6. The second processing cavity 102 cleans the carbon film on the surface of the inspected substrate, and transfers, from the second processing cavity to the substrate placing platform through the second moving apparatus 104, the substrate from which the carbon film is cleaned.

The first processing cavity 101 (which may also be referred to as a physical vapor deposition cavity) is configured to form the carbon film on the surface of the substrate in a physical vapor deposition manner. To be specific, the first processing cavity 101 is a deposition cavity in which the carbon film is deposited on the surface of the substrate, and the first processing cavity 101 may use the physical vapor deposition manner to enable carbon atoms, carbon ions, or the like to form a uniform carbon film on the surface of the substrate in the first processing cavity 101. Because of good conductivity, the uniform carbon film can conduct away, in time in a subsequent electron beam inspection process, charges generated when an electron beam is irradiated on the substrate, to prevent charged effect from being formed on the surface of the substrate, affecting an inspection result. The carbon film needs to be deposited on the surface of the substrate in a vacuum environment. Therefore, the first processing cavity 101 is still a vacuum cavity. In addition, the substrate may be understood as a to-be-inspected semiconductor product, for example, a wafer or mask.

It should be noted that the physical vapor deposition manner used by the first processing cavity 101 may include evaporation vapor deposition, sputtering vapor deposition, or the like. This is not limited in this embodiment of this application. For example, when the first processing cavity 101 is in a first vacuum environment, a target material is excited to obtain carbon atoms in a sputtering vapor deposition manner, and the carbon atoms form a carbon film on the surface of the substrate. The target material is solid-state carbon. In addition, a shape of the target material is not specifically limited in this embodiment of this application. For example, the target material may be round carbon, filamentous carbon, or rod-shaped carbon. In addition, a specific material of the target material is not specifically limited in this embodiment of this application. For example, the solid-state carbon may be graphite, diamond, or the like. A specific selected material may be specifically controlled based on costs.

The second processing cavity 102 is configured to perform electron beam scanning on the substrate with the surface on which the carbon film is deposited, and is further configured to clean, through oxygen plasma, the carbon film deposited on the surface of the scanned substrate. In other words, the second processing cavity 102 is a processing cavity that performs electron beam scanning on the substrate and cleans the carbon film on the surface of the substrate after the electron beam scanning. When the electron beam is irradiated on the substrate with the surface on which the carbon film is deposited, excess charges are conducted away in time through the carbon film on the surface of the substrate, so that no charge accumulation is formed on the surface of the to-be-inspected substrate, and the second processing cavity 102 can normally perform electron beam incidence and secondary electron emission, to obtain an observation result of the substrate, and determine whether the substrate has a physical defect. The physical defect may include, for example, a particle, an impurity, or a crack on the wafer or mask. After the electron beam scanning is completed, the carbon film on the surface of the substrate further needs to be cleaned, to prevent the inspected substrate from being contaminated by the carbon film. Therefore, the second processing cavity 102 may use an oxygen plasma technology to completely clean the carbon film deposited on the surface of the scanned substrate, so that the substrate from which the carbon film is cleaned is kept in a same state as the substrate existing when the carbon film is not deposited, in other words, the substrate from which the carbon film is cleaned is kept in a same state as the substrate existing before the carbon film is deposited, and there is no carbon on the surface. In addition, when electron beam inspection or carbon film cleaning is performed on the substrate, the substrate needs to be placed in a sealed vacuum cavity. Therefore, the second processing cavity 102 is also a sealable vacuum cavity.

It should be noted that the first processing cavity 101 and the second processing cavity 102 may share one vacuum pump to separately control vacuum environments in the cavities. Alternatively, the first processing cavity 101 and the second processing cavity 102 may each correspond to one vacuum pump, and control vacuum environments in the cavities in a one-to-one correspondence manner. This is not specifically limited in this embodiment of this application.

Optionally, the second processing cavity 102 is further configured to: before forming the carbon film on the surface of the substrate, clean the organic film on the surface of the substrate through oxygen plasma. When the substrate (for example, the wafer or mask) is produced at a normal temperature and pressure, the substrate may be often exposed to air due to a production process. When the substrate is exposed to air, an organic film (for example, a hydrocarbon) is extremely prone to be formed on the surface of the substrate due to breathing or communication of an operator, or even water vapor or other impurities in the air. This causes contamination to the surface of the substrate. Due to existence of the organic film on the surface of the substrate, a relatively large signal-to-noise ratio may occur in the electron beam inspection process, and purity of the deposited carbon film is affected. As a result, the carbon film is not pure and therefore conductivity of the carbon film is affected, affecting an electron beam inspection result. Therefore, before carbon film deposition, the organic film needs to be cleaned by using, for example, the oxygen plasma technology. For example, in the second processing cavity, a radio frequency voltage (a frequency is about tens of megahertz) is applied to a group of electrodes, and a high-frequency alternating electric field is formed between the electrodes. Under excitation of the alternating electric field, gas in the area generates high-energy disordered plasma. The active plasma performs dual effects of a physical bombardment and a chemical reaction on a surface of a cleaned object, so that a substance on the surface of the cleaned object becomes a particle and a gaseous substance and the particle and the gaseous substance are exhausted through vacuuming, to clean an impurity.

The first moving apparatus 103 may be understood as a vacuum transfer apparatus. To be specific, the first moving apparatus 103 may keep transferring the substrate between the first processing cavity and the second processing cavity in a vacuum environment.

Optionally, the first moving apparatus 103 may include a transfer module, a vacuum pump, and a vacuum cavity having at least one sealing door (for example, a metal valve). For example, when the first moving apparatus 103 transfers the substrate from the second processing cavity 102 to the first processing cavity 101 to deposit the carbon film, the vacuum cavity may first keep a same vacuum environment as the second processing cavity 102 through the vacuum pump, and then open a sealing door corresponding to the second processing cavity 102; transfer the substrate from a placing apparatus in the second processing cavity to a placing apparatus of the first moving platform through the substrate transfer module; and close the sealing door; and the vacuum cavity may adjust a vacuum degree in the cavity through the vacuum pump to keep a same vacuum environment as the first processing cavity 101, and then open a sealing door corresponding to the first processing cavity 101; transfer the substrate from the placing apparatus in the second processing cavity to the placing apparatus of the first moving platform through the substrate transfer module; and close the sealing door. Optionally, when there is only one sealing door, a corresponding position of the sealing door may be changed, to ensure smooth transfer of the substrate between different cavities. For example, the sealing door may be transferred from a position corresponding to the second processing cavity 102 to a position corresponding to the first processing cavity 101.

It should be noted that keeping the vacuum degree in the vacuum cavity consistent with a vacuum degree in the first processing cavity or the second processing cavity may be understood as that the vacuum degrees are consistent in magnitude, or may be understood as that the transferred substrate is not affected due to a vacuum degree change when the substrate is transferred between the two cavities.

The second moving apparatus 104 may be understood as a robot hand, a robot arm, or the like. To be specific, the second moving apparatus 104 may transfer the substrate from a placing apparatus at the normal temperature and pressure to the second processing cavity, or transfer the inspected substrate from the second processing cavity to the placing apparatus at the normal temperature and pressure. After the substrate is transferred to the second processing cavity, gas in the first processing cavity or the second processing cavity needs to be extracted through a vacuum pump, to form a vacuum environment. For example, after the second moving apparatus transfers the substrate from the substrate placing platform to the second processing cavity 102, the second processing cavity 102 is sealed, and gas in the second processing cavity is extracted through a vacuum pump, to keep the second processing cavity in a vacuum.

It should be noted that, the placing apparatus at the normal temperature and pressure may be understood as a substrate placing platform at a room temperature, and the platform may be exposed to air.

Optionally, the second moving apparatus 104 may move the substrate through a vacuum suction cup. The vacuum suction cup is not prone to cause damage or contamination to the substrate in a process of transferring the substrate.

The vacuum pump is a component or device that uses a mechanical, physical, chemical, or physical-chemical method to extract air from an extracted container to obtain a vacuum. In general, the vacuum pump is an apparatus that improves, generates, and keeps a vacuum in specific closed space by using various methods. In this embodiment of this application, the vacuum pump is configured to generate or keep vacuum environments in the first processing cavity 101, the second processing cavity 102, and the first moving apparatus 103. Both the first processing cavity 101 and the second processing cavity 102 are closeable vacuum cavities, and the first moving apparatus 103 includes a closeable vacuum cavity.

Optionally, the vacuum pump is configured to exhaust gas from the second processing cavity after the second processing cavity 102 cleans the carbon film on the surface of the scanned substrate through the oxygen plasma. In other words, a vacuum environment in the second processing cavity is kept through the vacuum pump. The vacuum pump can exhaust carbon dioxide gas, namely, a product of a reaction between the oxygen plasma and the carbon film, from the cavity in time. In addition, a type of the vacuum pump is not specifically limited in this embodiment of this application.

In conclusion, the electron beam inspection device includes two processing cavities that are independent of each other: the first processing cavity 101 and the second processing cavity 102. The first processing cavity is configured to deposit the ultrathin cleanable carbon film on the surface of the substrate (the to-be-inspected semiconductor product, namely, the wafer or mask) in the cavity. Because of good conductivity, the carbon film can conduct away charges accumulated on the surface of the substrate during electron beam inspection, to alleviate charged effect in an electron beam inspection process. In addition, the ultrathin carbon film deposited in the first processing cavity may reach a thickness less than 10 nm, thereby avoiding a problem that an inspection result is usually interfered with by a conductive film due to a thickness. In addition, the second processing cavity in the electron beam inspection device is configured to perform electron beam scanning on the substrate on which the ultrathin carbon film is deposited, to find a physical defect of the substrate. After completing the scanning, the second processing cavity may be further configured to clean the ultrathin carbon film on the surface of the substrate through the oxygen plasma. Because oxygen and carbon can undergo a combustion reaction (O₂+C=CO₂), the oxygen plasma can react with the carbon film on the surface of the substrate to generate carbon dioxide gas, to completely clean the carbon film on the surface of the substrate. In addition, the oxygen plasma almost does not react with a manufacturing material of the substrate (the wafer or mask). Therefore, on a premise that the carbon film is completely cleaned, the oxygen plasma can ensure that the substrate is not affected, thereby avoiding a problem that a to-be-inspected product is contaminated by an existing conductive film. **In** conclusion, because the electron beam inspection device includes the two processing cavities that are independent of each other, carbon film deposition, electron beam inspection, and complete carbon film cleaning can be separately implemented, thereby successfully avoiding charged effect caused by the electron beam inspection device on the surface of the to-be-inspected product in the inspection process, avoiding a problem that the substrate is contaminated by a conductive film and a problem that an inspection result is interfered with by the conductive film, and improving efficiency of performing electron beam inspection on the substrate.

It should be further noted that the related structure of the electron beam inspection device shown in FIG. 1 is merely an example structure provided in this application. In this embodiment of this application, shapes, sizes, positions, and even quantities of related components such as the first processing cavity 101, the second processing cavity 102, the first moving apparatus 103, the second moving apparatus 104, and the vacuum pump that is not shown in the figure are not specifically limited. For example, the first processing cavity 101 and the second processing cavity 102 may be cylindrical, hemispherical, cuboid, or the like, and positions of the first processing cavity 101 and the second processing cavity 102 may also be adjusted based on a limitation of a device size during specific application. For another example, to save device space, the first moving apparatus and the second moving apparatus may be suspended above the first processing cavity and the second processing cavity. For another example, to save device space and costs, a quantity of vacuum pumps may be further controlled. For example, the first processing cavity, the second processing cavity, and the first moving apparatus share one vacuum pump.

The second processing cavity for electron beam inspection and carbon film cleaning in the electron beam inspection device shown in FIG. 1 includes only one cavity. In some embodiments, the second processing cavity may be further divided into a plurality of cavities, or the second processing cavity further includes at least one cavity.

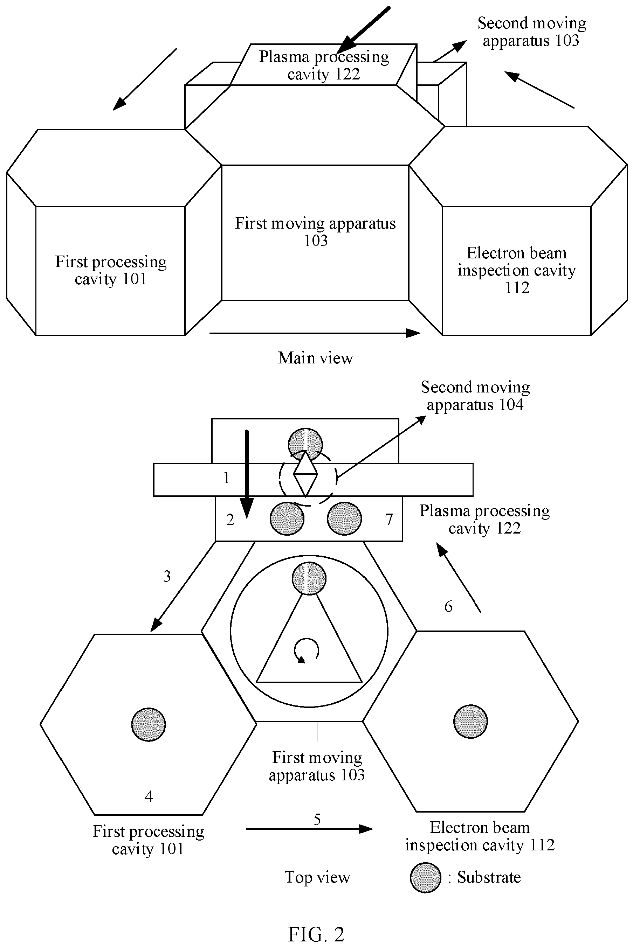

FIG. 2 is a diagram of a structure of another electron beam inspection device according to an embodiment of this application. As shown in a main view in FIG. 2, the electron beam inspection device may include a first processing cavity 101, an electron beam inspection cavity 112, and a plasma processing cavity 122. The electron beam inspection device may further include a first moving apparatus 103, a second moving apparatus 104, and a vacuum pump (not shown in the figure). It should be noted that, compared with that in the electron beam inspection device shown in FIG. 1, a second processing cavity in the electron beam inspection device shown in FIG. 2 is divided into the electron beam inspection cavity 112 and the plasma processing cavity 122. As shown in a top view in FIG. 2, the following operations are performed:
1. Transfer a substrate (a to-be-inspected semiconductor product, for example, a wafer or mask) from a substrate placing platform to the plasma processing cavity 122 through the second moving apparatus 104.
2. Clean an organic film on a surface of the substrate through plasma processing in the plasma processing cavity.
3. After the plasma processing cavity 122 cleans the organic film on the surface of the substrate, the electron beam inspection device transfers the substrate from the plasma processing cavity 122 to the first processing cavity 101 through the first moving apparatus 103.
4. Then, form a carbon film on the surface of the substrate by using a physical vapor deposition technology in the first processing cavity.
5. Then, the electron beam inspection device transfers, from the first processing cavity 101 to the electron beam inspection cavity 112 through the first moving apparatus 103, the substrate on which the carbon film is deposited, so that electron beam inspection is performed, in the second processing cavity, on the substrate on which the carbon film is deposited, to obtain a defect inspection result of the substrate.
6. After obtaining the defect inspection result of the substrate, the electron beam inspection device transfers the substrate from the electron beam inspection cavity 112 to the plasma processing cavity 122 through the first moving apparatus 103.
7. The plasma processing cavity 122 cleans the carbon film on the surface of the inspected substrate, and transfers, from the second processing cavity to the substrate placing platform through the second moving apparatus 104, the substrate from which the carbon film is cleaned.

The first processing cavity 101 is configured to form the carbon film on the surface of the substrate in a physical vapor deposition manner. For a function of the first processing cavity 101, further correspondingly refer to the related descriptions of the first processing cavity 101 in the electron beam inspection device shown in FIG. 1. Details are not described herein again in this embodiment of this application.

The electron beam inspection cavity 112 is configured to perform electron beam scanning on the substrate with the surface on which the carbon film is deposited. To be specific, the electron beam inspection cavity 112 irradiates an electron beam on the substrate to perform electron beam scanning, and excess charges are conducted away in time through the carbon film on the surface of the substrate, so that no charge accumulation is formed on the surface of the to-be-inspected substrate, and the electron beam inspection cavity 112 can normally perform electron beam incidence and secondary electron emission, to obtain an inspection result of the substrate. The inspection result may indicate whether the substrate has a physical defect. If the substrate has a physical defect, the inspection result may further include a type, a size, a position, and the like of the physical defect. For example, the inspection result may include image information and defect information of the substrate. When electron beam inspection is performed on the substrate, the substrate needs to be placed in a sealed vacuum cavity. Therefore, the electron beam inspection cavity 112 is a sealable vacuum cavity.

The plasma processing cavity 122 is configured to clean the carbon film on the surface of the scanned substrate through oxygen plasma. Because the electron beam inspection cavity 112 and the plasma processing cavity 122 are two cavities that are independent of each other, the plasma processing cavity can independently clean the carbon film without being affected by other factors. Therefore, after the electron beam scanning is completed, the scanned substrate further needs to be transferred from the electron beam inspection cavity 112 to the plasma processing cavity 122 through the first moving apparatus 103, to clean the carbon film on the surface of the substrate, thereby preventing the inspected substrate from being contaminated by the carbon film. For example, the plasma processing cavity 122 may use an oxygen plasma technology to completely clean the carbon film deposited on the surface of the scanned substrate, so that the substrate from which the carbon film is cleaned is in a same state as the substrate existing when the carbon film is not deposited. When carbon film cleaning is performed on the substrate, the substrate needs to be placed in a sealed vacuum cavity. Therefore, the plasma processing cavity 122 is a sealable vacuum cavity.

Optionally, the plasma processing cavity 122 is further configured to: before forming the carbon film on the surface of the substrate, clean the organic film on the surface of the substrate through oxygen plasma. When the substrate (for example, the wafer or mask) is produced at a normal temperature and pressure, the substrate may be often exposed to air due to a production process. When the substrate is exposed to air, an organic film is extremely prone to be formed on the surface of the substrate due to breathing or communication of an operator, or even an impurity in the air. This causes contamination to the substrate, affecting an electron beam inspection result. Therefore, before carbon film deposition, the organic film needs to be cleaned by using, for example, the oxygen plasma technology. This alleviates interference with an inspection result and impact on the substrate that are caused by the organic film.

The first moving apparatus 103 may be understood as a vacuum transfer apparatus. To be specific, the first moving apparatus 103 may transfer the substrate from the plasma processing cavity to the first processing cavity, from the first processing cavity to the electron beam inspection cavity, or from the electron beam inspection cavity to the plasma processing cavity. Due to a limitation of a process, in a process of inspecting the substrate, a transfer route of the first moving apparatus 103 is determined. To be specific, the substrate can be transferred only from the plasma processing cavity to the first processing cavity, or from the first processing cavity to the electron beam inspection cavity, or from the electron beam inspection cavity to the plasma processing cavity. Therefore, because of the fixed route and no mutual interference, the electron beam inspection device is applicable to a large-scale semiconductor manufacturing process, to form a pipeline operation, and help improve a production capacity of the semiconductor industry.

The second moving apparatus 104 may be understood as a robot hand, a robot arm, or the like. To be specific, the second moving apparatus 104 may transfer the substrate from a placing apparatus at the normal temperature and pressure to the plasma processing cavity, or transfer the inspected substrate from the plasma processing cavity to the placing apparatus at the normal temperature and pressure. After the substrate is transferred to the plasma processing cavity, gas in the plasma processing cavity needs to be extracted through a vacuum pump, to form a vacuum environment. After the substrate is transferred from the plasma processing cavity, the plasma processing cavity needs to be restored to an environment at the normal temperature and pressure through the vacuum pump.

The vacuum pump is configured to exhaust gas in the plasma processing cavity from the plasma processing cavity after the plasma processing cavity 122 cleans, through the oxygen plasma, the carbon film deposited on the surface of the scanned substrate.

It should be noted that for other related functions of the first moving apparatus 103, the second moving apparatus 104, and the vacuum pump, further correspondingly refer to the related descriptions in the embodiment in FIG. 1. Details are not described herein again in this embodiment of this application.

It should be further noted that the related structure of the electron beam inspection device shown in FIG. 2 in this embodiment of this application is merely an example structure provided in this application. In this embodiment of this application, shapes, sizes, positions, and even quantities of related components such as the first processing cavity 101, the electron beam inspection cavity 112, the plasma processing cavity 122, the first moving apparatus 103, the second moving apparatus 104, and the vacuum pump that is not shown in the figure are not specifically limited. For example, the plasma processing cavity 122 may be further divided into two processing cavities, where one processing cavity is configured to clean the organic film, and the other processing cavity is configured to clean the carbon film. This is not specifically limited in this embodiment of this application.

In conclusion, the electron beam inspection device includes at least three processing cavities that are independent of each other: the first processing cavity 101, the electron beam inspection cavity 112, and the plasma processing cavity 122. The electron beam inspection cavity and the plasma processing cavity are separated, so that the substrate cannot be affected due to another step in the processes of performing electron beam inspection and carbon film cleaning, and interference with an inspection result can also be avoided. In addition, carbon film deposition, electron beam inspection, and complete carbon film cleaning can be separately implemented, thereby successfully avoiding charged effect caused by the electron beam inspection device on the surface of the to-be-inspected product in the inspection process, avoiding a problem that the substrate is contaminated by a conductive film and a problem that an inspection result is interfered with by the conductive film, and improving efficiency of performing electron beam inspection on the substrate. In addition, during preparation of the ultrathin carbon film, key parameters, such as a vacuum degree and a voltage of a deposition cavity, for optimizing the carbon film may be set, to control a film thickness, a granularity, surface morphology, a defect rate, and the like of the ultrathin carbon film, to ensure that interference with an electron beam inspection result is close to zero, thereby ensuring that accuracy and definition of electron beam inspection are not affected. For example, when the vacuum degree is 1×10⁻³ Pa to 1×10⁻⁹ Pa and the voltage is 200 V to 8 kV, film thickness uniformity can be controlled within ±0.4 nm, and a granularity is less than 0.4 nm. Then, because the oxygen plasma technology can 100% clean the carbon film through a combustion reaction between oxygen and carbon, in this solution, a problem that an inspection result is interfered with by a conductive film and a problem that a product is contaminated by the conductive film are avoided, thereby ensuring a yield during large-scale production of related semiconductor apparatuses in the semiconductor manufacturing industry.

Therefore, in the following, this application uses the electron beam inspection device shown in FIG. 2 as an example to describe related parameters of the electron beam inspection device in a running process.

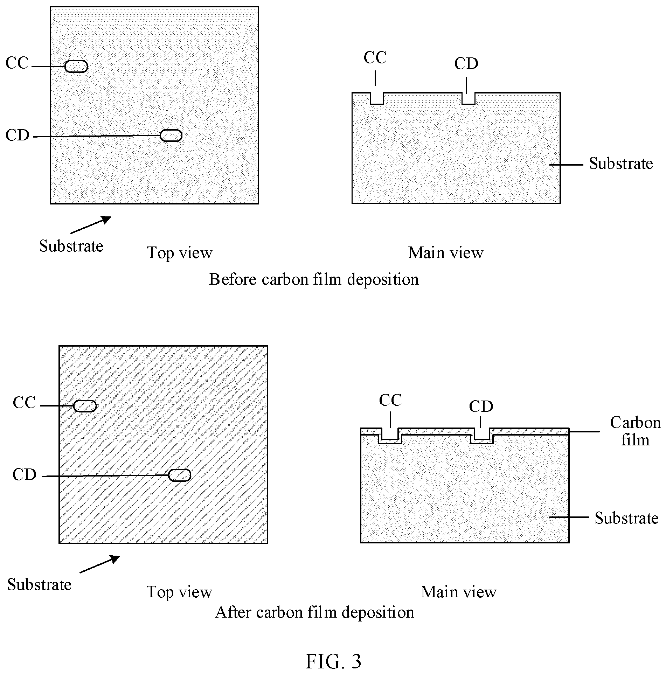

FIG. 3 is a diagram of a process based on the electron beam inspection device shown in FIG. 2 according to an embodiment of this application. As shown in FIG. 3, an optimized testing process based on the electron beam inspection device shown in FIG. 2 in embodiments of this application is as follows, including, for example, a physical vapor deposition process and a plasma processing process:
Step S1: Transfer a substrate from a substrate placing platform to the plasma processing cavity through the second moving apparatus. The substrate is a to-be-inspected semiconductor product, for example, a wafer or mask.
Step S2: Clean an organic film on a surface of the substrate by using a plasma processing technology in the plasma processing cavity. A voltage of the plasma processing cavity is set to 200 V to 8 kV, a vacuum degree in the plasma processing cavity is stabilized at 1×10⁻³ Pa to 1×10⁻⁷ Pa, and processing time of the plasma processing cavity is 10s to 600s.
   A relationship between a voltage, a vacuum degree, and processing time is as follows: A higher voltage indicates a higher concentration of oxygen plasma and shorter processing time of the plasma processing cavity, but indicates a higher temperature of the substrate. Therefore, an excessively high voltage may have negative impact on performance of the substrate. Therefore, an upper limit of the voltage may be set to about 8 kV. A higher vacuum degree in the cavity indicates a higher reaction speed of the oxygen plasma and the organic film and shorter processing time, but the higher vacuum degree indicates higher device and process costs. In this step, the organic film on the surface of the product is cleaned by using an oxygen plasma (O₂ Plasma) technology, to prepare for subsequent carbon film deposition on the surface of the substrate.
Step S3: After the plasma processing cavity cleans the organic film on the surface of the substrate, the electron beam inspection device transfers the substrate from the plasma processing cavity to the first processing cavity through the first moving apparatus.
Step S4: The electron beam inspection device forms a carbon film on the surface of the substrate by using a physical vapor deposition technology in the first processing cavity. A voltage of the first processing cavity is set to 200 V to 8 kV, a vacuum degree in the first processing cavity is stabilized at 1×10⁻³ Pa to 1×10⁻⁹ Pa, and deposition time of the first processing cavity is 10s to 600s. A thickness of the formed carbon film is less than 10 nm, and a granularity of the carbon film is less than 1 nm.

A relationship between a voltage, a vacuum degree, and processing time is as follows: A higher voltage indicates a higher concentration of carbon atoms filled in the cavity or carbon ions excited in the cavity and shorter deposition time. A higher vacuum degree in the first processing cavity indicates higher purity, better conductivity, and a smaller granularity value of the carbon film, but the higher vacuum degree indicates higher device and process costs. In this step, a uniform ultrathin carbon film is formed on the surface of the substrate, to prepare for subsequent electron beam defect inspection.

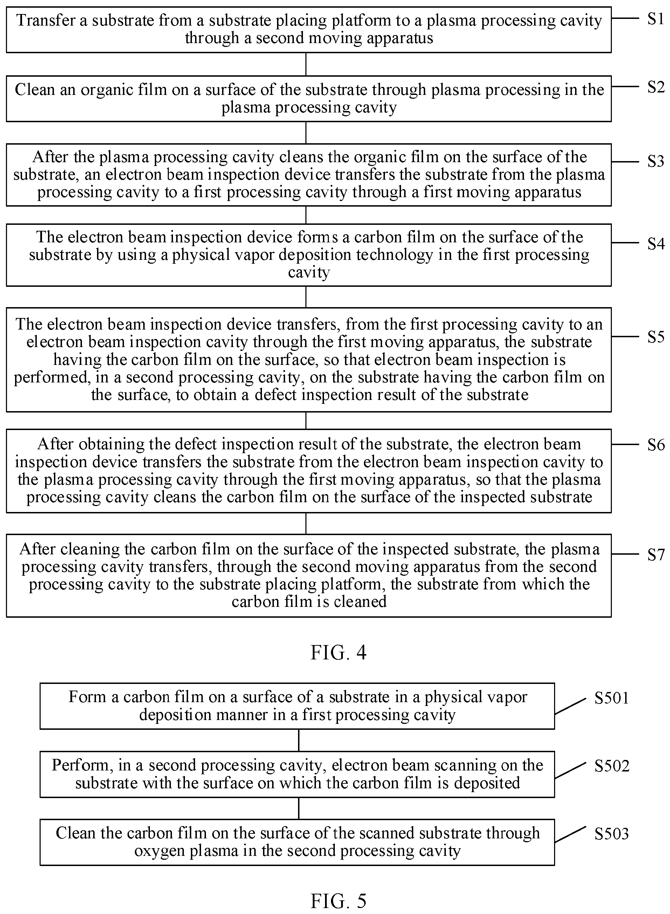

FIG. 4 is a diagram of a substrate structure existing before carbon film deposition and a substrate structure obtained after the carbon film deposition according to an embodiment of this application. As shown in FIG. 4, before the carbon film deposition, the substrate has two crack defects CC and CD. After the carbon film deposition, the surface of the substrate is covered by the uniform carbon film. Because the thickness of the carbon film may be controlled to be between 1 nm and 10 nm, the two crack defects CC and CD are not completely covered. Therefore, in a subsequent electron beam inspection process, the defects on the substrate can be clearly found while charged effect is avoided.

Step S5: The electron beam inspection device transfers, from the first processing cavity to the electron beam inspection cavity through the first moving apparatus, the substrate having the carbon film on the surface, so that electron beam inspection is performed, in the second processing cavity, on the substrate having the carbon film on the surface, to obtain a defect inspection result of the substrate. A voltage of the electron beam inspection cavity is set to 1 kV to 80 kV, a vacuum degree in the electron beam inspection cavity is stabilized at 1×10⁻² Pa to 1×10⁻⁹ Pa, and scanning time of the electron beam inspection cavity is 360s to 7200s.

A relationship between a voltage, a vacuum degree, and processing time is as follows: Herein, voltage setting is related to inspection resolution, and therefore modification may be performed based on an actual requirement. A higher voltage indicates higher scanning resolution of a generated image. A higher vacuum degree in the cavity indicates higher inspection quality, namely, higher accuracy of finding a defect of the substrate. In this step, information collection and/or image processing of the substrate may be completed.

Step S6: After obtaining the defect inspection result of the substrate, the electron beam inspection device transfers the substrate from the electron beam inspection cavity to the plasma processing cavity through the first moving apparatus, so that the plasma processing cavity cleans the carbon film on the surface of the inspected substrate. A voltage of the plasma processing cavity is set to 200 V to 8 kV, a vacuum degree in the plasma processing cavity is stabilized at 1×10⁻³ Pa to 1×10⁻⁷ Pa, and processing time (equivalent to cleaning time) is 10s to 600s.

A relationship between a voltage, a vacuum degree, and processing time is as follows: A higher voltage indicates a higher concentration of oxygen plasma and shorter processing time of the plasma processing cavity. A higher vacuum degree in the cavity indicates a higher reaction speed of the oxygen plasma and the carbon film and shorter processing time, but the higher vacuum degree indicates higher device and process costs. In this step, the carbon film on the surface of the product is combusted by using the oxygen plasma (O₂ Plasma) technology, to generate carbon dioxide gas. A reaction product includes only gas, namely, carbon dioxide, and is exhausted from the vacuum cavity through a vacuum pump, so that there is no solid or liquid impurity residue. In this step, a status of the substrate may be restored to that in step S1 through oxygen plasma processing.

Step S7: After cleaning the carbon film on the surface of the inspected substrate, the plasma processing cavity transfers, through the second moving apparatus from the second processing cavity to the substrate placing platform, the substrate from which the carbon film is cleaned.

It should be noted that, in this embodiment of this application, the processing time, the deposition time, the scanning time, or the like indicates only process time, and a value of the processing time, the deposition time, the scanning time, or the like is obtained with reference to a 12-inch wafer. Therefore, the processing time, the deposition time, the scanning time, or the like cannot indicate all cases, and the value of the processing time, the deposition time, the scanning time, or the like may be adjusted with a voltage, a vacuum degree, and a substrate size.

To resolve a problem that an inspection result is interfered with by a conductive film and a problem that a product is contaminated by the conductive film, an embodiment of this application provides a technology that can 100% clean a carbon film, to resolve charged effect that is a main technical challenge in the electron beam inspection field, and avoid a problem that an inspection result is interfered with by a conductive film and a problem that a substrate (a to-be-inspected product) is contaminated by the conductive film. In this embodiment of this application, an ultrathin (1 nm to 10 nm) cleanable carbon film is deposited on a surface of a substrate (for example, a wafer or light cover). In an electron beam inspection phase, charges accumulated on the surface of the product (the wafer or light cover) may be conducted outside the product through the carbon film, so that charged effect is fundamentally eliminated, and an electron beam inspection speed is not reduced. In addition, during preparation, vacuum degrees and voltages of a first processing cavity and a second processing cavity may be used to optimize key parameters of the carbon film, including a film thickness, a granularity, surface morphology, a defect rate, and the like, to ensure that interference with an electron beam inspection result is close to zero, thereby ensuring that accuracy and definition of electron beam inspection are not affected. Then, because oxygen plasma can 100% clean the carbon film, in this embodiment of this application, a problem that an inspection result is interfered with by a conductive film and a problem that a product is contaminated by the conductive film are avoided, thereby ensuring large-scale production of related semiconductor apparatuses in the semiconductor manufacturing industry.

Based on the related descriptions of the foregoing embodiments, this application provides, as examples, three implementations in which an electron beam inspection device sets, in an electron beam inspection process, a key parameter for optimizing a carbon film and electron beam inspection, to obtain different beneficial effects.
1. Electron beam inspection device and process costs are reduced on a premise that a problem that a to-be-inspected product is contaminated by a conductive film and a problem that an inspection result is interfered with by the conductive film are avoided.

For the foregoing step S2, the voltage of the plasma processing cavity is set to 220 V, the vacuum degree in the plasma processing cavity is stabilized at 1x10⁻³ Pa, and the processing time is 600s. In step S2, the organic film on the surface of the substrate may be cleaned by using the plasma technology, to prepare for subsequent carbon film deposition.

For the foregoing step S4, the substrate is transferred to the first processing cavity through the first moving apparatus (for example, a vacuum environment transfer platform), to start carbon film deposition. The voltage of the first processing cavity is set to 220 V, the vacuum degree in the first processing cavity is stabilized at 1x10⁻³ Pa, and the deposition time is 120s. The vacuum degree and the voltage may be set to form an ultrathin carbon film on the surface of the substrate. A thickness of the carbon film formed in the foregoing conditions is 2 nm, film thickness uniformity is controlled to be within ±0.4 nm, and a carbon granularity is less than 0.4 nm.

For the foregoing step S5, the substrate is moved to the electron beam inspection cavity through the first moving apparatus, to perform substrate defect inspection in the electron beam inspection cavity. The voltage of the electron beam inspection cavity is 20 kV to 80 kV, the vacuum degree in the electron beam inspection cavity is stabilized at 1×10⁻² Pa to 1×10⁻⁵ Pa, and the electron beam scanning time of the electron beam inspection cavity is 3600s to 7200s. A higher vacuum degree indicates shorter scanning time of the electron beam inspection cavity. In this step, information collection and image processing of the substrate may be completed.

For the foregoing step S6, the substrate is moved to the plasma processing cavity through the first moving apparatus. The voltage of the plasma processing cavity is set to 220 V, the vacuum degree in the plasma processing cavity is stabilized at 1x10⁻³ Pa, and the processing time is 30s. In this step, the carbon film on the surface of the substrate is combusted by using the oxygen plasma technology, to generate carbon dioxide gas. Because the deposited carbon film is ultrathin and has higher purity, the processing time is shorter than that of the organic film.

In conclusion, a higher voltage and a higher vacuum degree in a processing cavity indicate higher electron beam inspection device and process costs. Therefore, the foregoing voltage and vacuum degree configuration is implemented, so that electron beam inspection device and process costs can be greatly reduced on a premise that a problem that a to-be-inspected product is contaminated by a conductive film and a problem that an inspection result is interfered with by the conductive film are avoided.

2. On a premise that a problem that a to-be-inspected product is contaminated by a conductive film and a problem that an inspection result is interfered with by the conductive film are avoided, a voltage and a vacuum degree in a cavity of an electron beam inspection device are kept constant, to balance costs of a carbon film and electron beam inspection accuracy, so that production of a substrate is relatively high.

For the foregoing step S2, the voltage of the plasma processing cavity is set to 2 kV, the vacuum degree in the plasma processing cavity is stabilized at 5×10⁻⁵ Pa, and the processing time of the plasma processing cavity is 30s. In this step, the organic film on the surface of the substrate is cleaned by using the oxygen plasma (O₂ Plasma) technology, to prepare for subsequent carbon film deposition.

For the foregoing step S4, the substrate is transferred to the first processing cavity through the first moving apparatus, to start carbon film deposition. The voltage of the first processing cavity is set to 7 kV, the vacuum degree in the first processing cavity is stabilized at 1×10⁻⁹ Pa, and the deposition time of the first processing cavity is 10s. The vacuum degree and the voltage may be set to form an ultrathin carbon film on the surface of the substrate. A thickness of the carbon film formed in the foregoing conditions is 1 nm, and a carbon granularity is less than 0.3 nm.

For the foregoing step S5, the substrate is moved to the electron beam inspection cavity through the first moving apparatus, to perform substrate defect inspection in the electron beam inspection cavity. The voltage of the electron beam inspection cavity is set to 1 kV to 80 kV, the vacuum degree in the cavity is stabilized at 1×10⁻⁵ Pa to 1×10⁻⁹ Pa, and the processing time is 360s to 7200s. In this step, information collection and image processing of the substrate are completed.

For the foregoing step S6, the substrate is moved to the plasma processing cavity through the first moving apparatus. The voltage of the plasma processing cavity is set to 2 kV, the vacuum degree in the plasma processing cavity is stabilized at 5×10⁻⁵ Pa, and the processing time of the plasma processing cavity is 20s.

The foregoing process conditions balance processing time and costs, so that the substrate has highest inspection efficiency and is applicable to the large-scale semiconductor manufacturing industry.

In conclusion, a higher voltage and a higher vacuum degree in a processing cavity indicate higher electron beam inspection device and process costs. Therefore, the foregoing voltage and vacuum degree configuration is implemented, so that costs of carbon film manufacturing and electron beam inspection accuracy can be balanced on a premise that a problem that a to-be-inspected product is contaminated by a conductive film and a problem that an inspection result is interfered with by the conductive film are avoided. In this way, an inspection process consumes much less time compared with that in the implementation 1, thereby improving a production capacity of the substrate.

3. On a premise that a problem that a to-be-inspected product is contaminated by a conductive film and a problem that an inspection result is interfered with by the conductive film are avoided, quality of a carbon film is the best, and electron beam inspection device and process costs are the highest.

For the foregoing step S2, the voltage of the plasma processing cavity is set to 7 kV, the vacuum degree in the plasma processing cavity is stabilized at 1×10⁻⁷ Pa, and the processing time of the plasma processing cavity is 300s. A primary consideration for the foregoing process conditions is that an organic film cleaning effect is the best.

For the foregoing step S4, the substrate is transferred to the first processing cavity through the first moving apparatus (for example, a vacuum environment transfer platform), to start carbon film deposition. The voltage of the first processing cavity is set to 2 kV, the vacuum degree in the first processing cavity is stabilized at 1×10⁻⁹ Pa, and the deposition time of the first processing cavity is 40s. The vacuum degree and the voltage may be set to form an ultrathin carbon film on the surface of the substrate, where quality (such as conductivity, a thickness, or uniformity) of the carbon film is the best compared with that in the foregoing two embodiments. The thickness of the carbon film formed in the foregoing conditions is 2 nm, and a carbon granularity is less than 0.2 nm.

For the foregoing step S5, the substrate is moved to the electron beam inspection cavity through the first moving apparatus, to perform substrate defect inspection in the electron beam inspection cavity. The voltage of the electron beam inspection cavity is set to 20 kV to 80 kV, the vacuum degree in the cavity is stabilized at 1×10⁻⁸ Pa to 1×10⁻⁹ Pa, and the processing time is 360s to 1800s. In this case, because the quality of the carbon film is relatively good, a signal-to-noise ratio is the highest during electron beam inspection.

For the foregoing step S6, the substrate is moved to the plasma processing cavity through the first moving apparatus. The voltage of the plasma processing cavity is set to 7kV, the vacuum degree in the plasma processing cavity is stabilized at 1×10⁻⁵ Pa, and the processing time of the plasma processing cavity is 40s. In this step, a status of the substrate is restored to that in step 1 through plasma processing. In the foregoing process conditions, because the quality of the deposited carbon film is the best compared with that in the foregoing two embodiments, in this case, the processing time for cleaning the carbon film is the shortest.

In conclusion, a higher voltage and a higher vacuum degree in a processing cavity indicate higher electron beam inspection device and process costs. Therefore, the foregoing voltage and vacuum degree configuration is implemented without consideration of electron beam inspection device and process costs, so that the quality of the carbon film can be greatly improved.

It should be noted that, in the foregoing three embodiments, the processing time, the deposition time, the scanning time, or the like indicates only process time, and a value of the processing time, the deposition time, the scanning time, or the like is obtained with reference to a 12-inch wafer. Therefore, the processing time, the deposition time, the scanning time, or the like cannot indicate all cases, and the value of the processing time, the deposition time, the scanning time, or the like may be adjusted with a voltage, a vacuum degree, and a substrate size.

It should be further noted that, in the foregoing three embodiments, a configuration manner of parameters such as a voltage and a vacuum degree is merely a possible implementation provided in embodiments of this application. Specific values of the parameters such as the voltage and the vacuum degree may be adjusted based on an actual case. Details are not described herein in embodiments of this application.

FIG. 5 is a flowchart of steps of an inspection method according to an embodiment of this application. The inspection method is applied to an electron beam inspection device, and the electron beam inspection device includes a first processing cavity and a second processing cavity. The method includes the following steps.

Step S501: Form a carbon film on a surface of a substrate in a physical vapor deposition manner in the first processing cavity.

Specifically, the electron beam inspection device forms the carbon film on the surface of the substrate in the physical vapor deposition manner in the first processing cavity. Physical vapor deposition may include evaporation vapor deposition, sputtering vapor deposition, or the like. A proper vacuum environment may be kept in the first processing cavity through a vacuum pump. Compared with that deposited in a chemical vapor deposition manner, the carbon film deposited in the physical vapor deposition manner is more uniform, has higher purity, and has a thickness that is easier to control. This helps perform electron beam inspection on the substrate.

Optionally, a thickness of the carbon film is less than 10 nm. If a conductive film is too thick, original morphology of the surface of the sample may be covered, and specific impact may be caused for sample composition analysis. A film prepared by using a vacuum sputtering coating method currently used in a laboratory is too thick. In addition, the film causes noise for an electron inspection signal. When a noise reduction function of the device is insufficient to compensate for a thickness of the film, both repeatability and accuracy of an inspection result are affected. Therefore, the thickness of the carbon film in this embodiment of this application may be less than 10 nm, thereby preventing an inspection result is interfered with by the carbon film. In addition, it should be noted that, the thickness of the ultrathin carbon film in this application and the foregoing embodiments is less than 10 nm. It may be understood that an actual thickness of the carbon film is less than or equal to 10 nm. In addition, it may also be understood that a prepared thickness of the carbon film is expected to be less than or equal to 10 nm but exceeds 10 nm due to a process limitation. For example, when a thickness of a carbon film is controlled to be 10 nm, due to a process limitation, film thickness uniformity is controlled to be within ±0.4 nm. As a result, actual thicknesses of some or all areas of the carbon film exceed 10 nm but are less than 10.4 nm. However, the carbon film may also be considered as an ultrathin carbon film formed on the surface of the substrate in the physical vapor deposition manner in the first processing cavity in this embodiment of this application.

Optionally, the forming a carbon film on a surface of a substrate in a physical vapor deposition manner in the first processing cavity includes: when the first processing cavity is in a first vacuum environment, forming the carbon film on the surface of the substrate in the physical vapor deposition manner, where a vacuum degree of the first vacuum environment is 1×10⁻³ Pa to 1×10⁻⁹ Pa, a voltage of the first processing cavity is 200 V to 8 kV, and deposition time of the first processing cavity is 10s to 600s. A higher vacuum degree of the first vacuum environment indicates a smaller granularity of the carbon film, and therefore indicates higher purity and better conductivity of the carbon film, thereby greatly avoiding charged effect in an electron beam inspection process.

Step S502: Perform, in the second processing cavity, electron beam scanning on the substrate with the surface on which the carbon film is deposited.

Specifically, in the second processing cavity, electron beam scanning is performed on the substrate with the surface on which the carbon film is deposited.

Optionally, the performing, in the second processing cavity, electron beam scanning on the substrate with the surface on which the carbon film is deposited includes: when the second processing cavity is in a second vacuum environment, performing electron beam scanning on the substrate with the surface on which the carbon film is deposited, where a vacuum degree of the second vacuum environment is 1×10⁻⁸ Pa to 1×10⁻⁹ Pa, a voltage of the second processing cavity is 20 kV to 80 kV, and scanning time of the second processing cavity is 360s to 1800s. The second processing cavity may obtain defect information or image information of the substrate after performing electron beam scanning on the substrate, with the surface on which the carbon film is deposited, in the second processing cavity. A higher vacuum degree of the second vacuum environment and a higher voltage of the electron beam inspection cavity indicate higher resolution of the image information corresponding to the substrate and shorter electron beam scanning time of the electron beam inspection cavity.

Optionally, the second processing cavity includes an electron beam inspection cavity, and the performing, in the second processing cavity, electron beam scanning on the substrate with the surface on which the carbon film is deposited includes: performing, in the electron beam inspection cavity, electron beam scanning on the substrate with the surface on which the carbon film is deposited.

Step S503: Clean the carbon film on the surface of the scanned substrate through oxygen plasma in the second processing cavity.

Specifically, the carbon film on the surface of the scanned substrate is cleaned through the oxygen plasma in the second processing cavity.

Optionally, the electron beam inspection device further includes a first moving apparatus, and the method further includes: transferring the substrate between the first processing cavity and the second processing cavity through the first moving apparatus.

Optionally, the electron beam inspection device further includes a second moving apparatus, and the method further includes: transferring the substrate at a normal temperature and pressure to the second processing cavity through the second moving apparatus.

Optionally, the cleaning the carbon film on the surface of the scanned substrate through oxygen plasma in the second processing cavity includes: when the second processing cavity is in a third vacuum environment, cleaning the carbon film on the surface of the scanned substrate through the oxygen plasma, where a vacuum degree of the third vacuum environment is 1×10⁻³ Pa to 1×10⁻⁷ Pa, a voltage of the second processing cavity is 200 V to 8 kV, and cleaning time of the second processing cavity is 10s to 600s. A higher vacuum degree in the plasma processing cavity indicates a higher reaction speed of the oxygen plasma and the carbon film in the plasma processing cavity and shorter processing time of the plasma processing cavity. A higher voltage of the plasma processing cavity indicates a higher concentration of the oxygen plasma in the plasma processing cavity and shorter processing time of the plasma processing cavity.

Optionally, the second processing cavity further includes a plasma processing cavity, and the cleaning the carbon film on the surface of the scanned substrate through oxygen plasma in the second processing cavity includes: cleaning the carbon film on the surface of the scanned substrate through the oxygen plasma in the plasma processing cavity.

Optionally, before the forming a carbon film on a surface of a substrate in a physical vapor deposition manner in the first processing cavity, the method further includes: cleaning an organic film on the surface of the substrate through oxygen plasma in the plasma processing cavity.

Optionally, before the forming a carbon film on a surface of a substrate in a physical vapor deposition manner in the first processing cavity, the method further includes: when the plasma processing cavity is in a fourth vacuum environment, cleaning the organic film on the surface of the substrate by using an oxygen plasma technology, where a vacuum degree of the fourth vacuum environment is 1×10⁻³ Pa to 1×10⁻⁷ Pa, processing time of the plasma processing cavity is 10s to 600s, and a voltage of the plasma processing cavity is 200 V to 8 kV.

Optionally, the transferring the substrate between the first processing cavity and the second processing cavity through the first moving apparatus includes: transferring the substrate from the plasma processing cavity to the first processing cavity, from the first processing cavity to the electron beam inspection cavity, or from the electron beam inspection cavity to the plasma processing cavity through the first moving apparatus.

Optionally, the transferring the substrate at a normal temperature and pressure to the second processing cavity through the second moving apparatus includes: transferring the substrate at the normal temperature and pressure to the plasma processing cavity through the second moving apparatus.

Optionally, the method further includes: transferring the substrate in the second processing cavity to the normal temperature and pressure through the second moving apparatus; or transferring the substrate in the plasma processing cavity to the normal temperature and pressure through the second moving apparatus.

Optionally, the electron beam device further includes a vacuum pump; and after the cleaning, through oxygen plasma in the second processing cavity, the carbon film deposited on the surface of the scanned substrate, the method further includes: exhausting gas from the second processing cavity through the vacuum pump.

In the inspection method applicable to the foregoing electron beam inspection device, the first processing cavity in the electron beam inspection device deposits a uniform ultrathin cleanable carbon film on the surface of the substrate (a to-be-inspected semiconductor product, namely, a wafer or mask) in the first processing cavity. Because of good conductivity, the carbon film can conduct away charges accumulated on the surface of the substrate during electron beam inspection, to alleviate charged effect in an electron beam inspection process. In addition, the ultrathin carbon film deposited in the first processing cavity may reach a thickness less than 10 nm, thereby avoiding a problem that an inspection result is usually interfered with by a conductive film due to a thickness. The second processing cavity in the electron beam inspection device performs electron beam scanning on the substrate on which the ultrathin carbon film is deposited, to find a physical defect of the substrate. After completing the scanning, the second processing cavity may further clean the ultrathin carbon film on the surface of the substrate through the oxygen plasma. Because oxygen and carbon can undergo a combustion reaction (O₂+C=CO₂), the oxygen plasma can react with the carbon film on the surface of the substrate to generate carbon dioxide gas, to completely clean the carbon film on the surface of the substrate, thereby avoiding a problem that a to-be-inspected product is contaminated due to incomplete cleaning of an existing conductive film. In addition, in the second processing cavity, an oxygen plasma amount may be controlled to be far greater than a carbon film amount. Therefore, the carbon film can be completely cleaned (100% cleaned), so that the carbon film does not have any residue on the surface of the substrate. In addition, the oxygen plasma almost does not react with a manufacturing material of the substrate (the wafer or mask). Therefore, on a premise that the carbon film is completely cleaned, the oxygen plasma can further ensure that the substrate is not affected. In addition, because the used electron beam inspection device includes two processing cavities that are independent of each other, a carbon film deposition process may be separated from an electron beam inspection process and a carbon film cleaning process, so that all processes do not interfere with each other and are orderly, thereby improving efficiency of performing electron beam inspection on the substrate.

It should be noted that for related descriptions of step S501 to step S503 in this embodiment of this application, further correspondingly refer to the related descriptions of the embodiment shown in FIG. 3. This is not described in detail again in this embodiment of this application.

In the foregoing embodiments, the descriptions of the embodiments have respective focuses. For a part that is not described in detail in an embodiment, refer to related descriptions in other embodiments.

It should be noted that, for brief description, the foregoing method embodiments each are represented as a combination of a series of actions. However, persons skilled in the art should appreciate that this application is not limited to the described order of the actions, because some steps may be performed in other orders or simultaneously according to this application. It should be further appreciated by persons skilled in the art that embodiments described in this specification all belong to example embodiments, and the involved actions and modules are not necessarily required by this application.

In the several embodiments provided in this application, it should be understood that the disclosed apparatus may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical or other forms.

The foregoing units described as separate parts may or may not be physically separate, and parts displayed as units may or may not be physical units, to be specific, may be located in one position, or may be distributed on a plurality of network units. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the foregoing integrated unit is implemented in the form of a software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in the form of a software product. The computer software product is stored in a storage medium and includes several instructions for instructing a computer device (which may be a personal computer, a server, a network device, or the like, and may be specifically a processor in the computer device) to perform all or some of the steps of the methods described in embodiments of this application. The foregoing storage medium may include any medium that can store program code, such as a USB flash drive, a removable hard disk, a magnetic disk, an optical disc, a read-only memory (Read-Only Memory, ROM for short), or a random access memory (Random Access Memory, RAM for short).

The invention is defined by the appended claims. Some embodiment variations may be considered by the skilled person as long as they belong to the scope of the invention.

## Claims

1. An electron beam inspection device, wherein the device comprises a first processing cavity and a second processing cavity,
the first processing cavity (101) is configured to form a carbon film on a surface of a substrate in a physical vapor deposition manner, and
the second processing cavity (102) is configured to perform electron beam scanning on the substrate with the surface on which the carbon film is deposited,
the electron beam inspection device being **characterized in that** the second processing cavity is further configured to clean the carbon film on the surface of the scanned substrate through oxygen plasma

2. The device according to claim 1, wherein the second processing cavity is further configured to: before forming the carbon film on the surface of the substrate, clean an organic film on the surface of the substrate through oxygen plasma

3. The device according to claim 1 or 2, wherein the device further comprises a first moving apparatus (103), and the first moving apparatus is configured to transfer the substrate between the first processing cavity and the second processing cavity.

4. The device according to any one of claims 1 to 3, wherein the device further comprises a second moving apparatus (104), and the second moving apparatus is configured to transfer the substrate at a normal temperature and pressure to the second processing cavity.

5. The device according to any one of claims 1 to 4, wherein the second processing cavity comprises an electron beam inspection cavity (112), and the electron beam inspection cavity is configured to perform electron beam scanning on the substrate with the surface on which the carbon film is deposited.

6. The device according to claim 5, wherein the second processing cavity further comprises a plasma processing cavity, and the plasma processing cavity (122) is configured to clean the carbon film on the surface of the scanned substrate through the oxygen plasma

7. The device according to claim 6, wherein the plasma processing cavity is further configured to: before forming the carbon film on the surface of the substrate, clean the organic film on the surface of the substrate through the oxygen plasma

8. The device according to claim 6 or 7, wherein the first moving apparatus is further configured to transfer the substrate from the plasma processing cavity to the first processing cavity, from the first processing cavity to the electron beam inspection cavity, or from the electron beam inspection cavity to the plasma processing cavity.

9. The device according to any one of claims 6 to 8, wherein the second moving apparatus is configured to transfer the substrate at the normal temperature and pressure to the plasma processing cavity.

10. The device according to any one of claims 1 to 9, wherein the device further comprises a vacuum pump, and the vacuum pump is configured to exhaust gas from the second processing cavity after the carbon film on the surface of the scanned substrate is cleaned through the oxygen plasma.

11. An inspection method, applied to an electron beam inspection device, wherein the electron beam inspection device comprises a first processing cavity (101) and a second processing cavity (102), and the method comprises:
forming a carbon film on a surface of a substrate in a physical vapor deposition manner in the first processing cavity;
performing, in the second processing cavity, electron beam scanning on the substrate with the surface on which the carbon film is deposited;
the inspection method being **characterized in that** it further comprises the following step:
cleaning the carbon film on the surface of the scanned substrate through oxygen plasma in the second processing cavity.

12. The method according to claim 11, wherein a thickness of the carbon film is less than 10 nm.

13. The method according to claim 11 or 12, wherein before the forming a carbon film on a surface of the substrate in a physical vapor deposition manner in the first processing cavity, the method further comprises:
cleaning an organic film on the surface of the substrate through oxygen plasma in the second processing cavity.

14. The method according to any one of claims 11 to 13, wherein the electron beam inspection device further comprises a first moving apparatus (103), and the method further comprises:
transferring the substrate between the first processing cavity and the second processing cavity through the first moving apparatus.

15. The method according to any one of claims 11 to 14, wherein the electron beam inspection device further comprises a second moving apparatus (104), and the method further comprises:
transferring the substrate at a normal temperature and pressure to the second processing cavity through the second moving apparatus.

## Patentansprüche

1. Elektronenstrahlinspektionsvorrichtung, wobei die Vorrichtung einen ersten Verarbeitungshohlraum und einen zweiten Verarbeitungshohlraum umfasst;
der erste Verarbeitungshohlraum (101) dazu konfiguriert ist, in einer physischen Dampfabscheidungsweise einen Kohlenstofffilm auf einer Oberfläche eines Substrats zu bilden; und
der zweite Verarbeitungshohlraum (102) dazu konfiguriert ist, eine Elektronenstrahlabtastung an dem Substrat mit der Oberfläche, auf welcher der Kohlenstofffilm abgeschieden ist, durchzuführen, wobei die Elektronenstrahlinspektionsvorrichtung **dadurch gekennzeichnet ist, dass** der zweite Verarbeitungshohlraum ferner dazu konfiguriert ist, den Kohlenstofffilm auf der Oberfläche des abgetasteten Substrats über Sauerstoffplasma zu reinigen.

2. Vorrichtung nach Anspruch 1, wobei der zweite Verarbeitungshohlraum ferner zu Folgendem konfiguriert ist: vor dem Bilden des Kohlenstofffilms auf der Oberfläche des Substrats, Reinigen eines organischen Films auf der Oberfläche des Substrats über Sauerstoffplasma.

3. Vorrichtung nach Anspruch 1 oder 2, wobei die Vorrichtung ferner eine erste bewegliche Einrichtung (103) umfasst und die erste bewegliche Einrichtung dazu konfiguriert ist, das Substrat zwischen dem ersten Verarbeitungshohlraum und dem zweiten Verarbeitungshohlraum zu übertragen.

4. Vorrichtung nach einem der Ansprüche 1 bis 3, wobei die Vorrichtung ferner eine zweite bewegliche Einrichtung (104) umfasst und die zweite bewegliche Einrichtung dazu konfiguriert ist, das Substrat bei einer/einem normalen Temperatur und Druck in den zweiten Verarbeitungshohlraum zu übertragen.

5. Vorrichtung nach einem der Ansprüche 1 bis 4, wobei der zweite Verarbeitungshohlraum einen Elektronenstrahlinspektionshohlraum (112) umfasst und der Elektronenstrahlinspektionshohlraum dazu konfiguriert ist, die Elektronenstrahlabtastung an dem Substrat mit der Oberfläche, auf welcher der Kohlenstofffilm abgeschieden ist, durchzuführen.

6. Vorrichtung nach Anspruch 5, wobei der zweite Verarbeitungshohlraum ferner einen Plasmaverarbeitungshohlraum umfasst und der Plasmaverarbeitungshohlraum (122) dazu konfiguriert ist, den Kohlenstofffilm auf der Oberfläche des abgetasteten Substrats über das Sauerstoffplasma zu reinigen.

7. Vorrichtung nach Anspruch 6, wobei der Plasmaverarbeitungshohlraum ferner zu Folgendem konfiguriert ist: vor dem Bilden des Kohlenstofffilms auf der Oberfläche des Substrats, Reinigen des organischen Films auf der Oberfläche des Substrats über das Sauerstoffplasma.

8. Vorrichtung nach Anspruch 6 oder 7, wobei die erste bewegliche Einrichtung ferner dazu konfiguriert ist, das Substrat von dem Plasmaverarbeitungshohlraum in den ersten Verarbeitungshohlraum, von dem ersten Verarbeitungshohlraum in den Elektronenstrahlinspektionshohlraum oder von dem Elektronenstrahlinspektionshohlraum in den Plasmaverarbeitungshohlraum zu übertragen.

9. Vorrichtung nach einem der Ansprüche 6 bis 8, wobei die zweite bewegliche Einrichtung dazu konfiguriert ist, das Substrat bei der/dem normalen Temperatur und Druck in den Plasmaverarbeitungshohlraum zu übertragen.

10. Vorrichtung nach einem der Ansprüche 1 bis 9, wobei die Vorrichtung ferner eine Vakuumpumpe umfasst und die Vakuumpumpe dazu konfiguriert ist, Gas aus dem zweiten Verarbeitungshohlraum auszustoßen, nachdem der Kohlenstofffilm auf der Oberfläche des abgetasteten Substrats über das Sauerstoffplasma gereinigt wurde.

11. Inspektionsverfahren, das auf eine Elektronenstrahlinspektionsvorrichtung angewandt wird, wobei die Elektronenstrahlinspektionsvorrichtung einen ersten Verarbeitungshohlraum (101) und einen zweiten Verarbeitungshohlraum (102) umfasst und das Verfahren Folgendes umfasst:
Bilden eines Kohlenstofffilms auf einer Oberfläche eines Substrats in einer physischen Dampfabscheidungsweise in dem ersten Verarbeitungshohlraum;
Durchführen, in dem zweiten Verarbeitungshohlraum, einer Elektronenstrahlabtastung an dem Substrat mit der Oberfläche, auf welcher der Kohlenstofffilm abgeschieden ist;
wobei das Inspektionsverfahren **dadurch gekennzeichnet ist, dass** es ferner den folgenden Schritt umfasst:
Reinigen des Kohlenstofffilms auf der Oberfläche des abgetasteten Substrats über Sauerstoffplasma in dem zweiten Verarbeitungshohlraum.

12. Verfahren nach Anspruch 11, wobei eine Dicke des Kohlenstofffilms kleiner als 10 nm ist.

13. Verfahren nach Anspruch 11 oder 12, wobei das Verfahren vor dem Bilden eines Kohlenstofffilms auf einer Oberfläche des Substrats in einer physischen Dampfabscheidungsweise in dem ersten Verarbeitungshohlraum ferner Folgendes umfasst:
Reinigen eines organischen Films auf der Oberfläche des Substrats über Sauerstoffplasma in dem zweiten Verarbeitungshohlraum.

14. Verfahren nach einem der Ansprüche 11 bis 13, wobei die Elektronenstrahlinspektionsvorrichtung ferner eine erste bewegliche Einrichtung (103) umfasst und das Verfahren ferner Folgendes umfasst:
Übertragen des Substrats zwischen dem ersten Verarbeitungshohlraum und dem zweiten Verarbeitungshohlraum über die erste bewegliche Einrichtung.

15. Verfahren nach einem der Ansprüche 11 bis 14, wobei die Elektronenstrahlinspektionsvorrichtung ferner eine zweite bewegliche Einrichtung (104) umfasst und das Verfahren ferner Folgendes umfasst:
Übertragen des Substrats bei einer/einem normalen Temperatur und Druck in den zweiten Verarbeitungshohlraum über die zweite bewegliche Einrichtung.

## Revendications

1. Dispositif d'inspection par faisceau d'électrons, dans lequel le dispositif comprend une première cavité de traitement et une seconde cavité de traitement ;
la première cavité de traitement (101) est configurée pour former un film de carbone sur une surface d'un substrat par dépôt physique en phase vapeur ; et
la seconde cavité de traitement (102) est configurée pour réaliser un balayage par faisceau d'électrons sur le substrat avec la surface sur laquelle le film de carbone est déposé, le dispositif d'inspection par faisceau d'électrons étant **caractérisé en ce que** la seconde cavité de traitement est également configurée pour nettoyer le film de carbone sur la surface du substrat balayé par plasma d'oxygène.

2. Dispositif selon la revendication 1, dans lequel la seconde cavité de traitement est également configurée pour : avant de former le film de carbone sur la surface du substrat, nettoyer un film organique sur la surface du substrat par plasma d'oxygène.

3. Dispositif selon la revendication 1 ou 2, dans lequel le dispositif comprend également un premier appareil mobile (103), et le premier appareil mobile est configuré pour transférer le substrat entre la première cavité de traitement et la seconde cavité de traitement.

4. Dispositif selon l'une quelconque des revendications 1 à 3, dans lequel le dispositif comprend également un second appareil mobile (104), et le second appareil mobile est configuré pour transférer le substrat à une température normale et à une pression normale vers la seconde cavité de traitement.

5. Dispositif selon l'une quelconque des revendications 1 à 4, dans lequel la seconde cavité de traitement comprend une cavité d'inspection par faisceau d'électrons (112), et la cavité d'inspection par faisceau d'électrons est configurée pour réaliser un balayage par faisceau d'électrons sur le substrat avec la surface sur laquelle le film de carbone est déposé.

6. Dispositif selon la revendication 5, dans lequel la seconde cavité de traitement comprend également une cavité de traitement plasma, et la cavité de traitement plasma (122) est configurée pour nettoyer le film de carbone sur la surface du substrat balayé par le plasma d'oxygène.

7. Dispositif selon la revendication 6, dans lequel la cavité de traitement plasma est également configurée pour : avant de former le film de carbone sur la surface du substrat, nettoyer le film organique sur la surface du substrat par le plasma d'oxygène.

8. Dispositif selon la revendication 6 ou 7, dans lequel le premier appareil mobile est également configuré pour transférer le substrat de la cavité de traitement plasma à la première cavité de traitement, de la première cavité de traitement à la cavité d'inspection par faisceau d'électrons, ou de la cavité d'inspection par faisceau d'électrons à la cavité de traitement plasma.

9. Dispositif selon l'une quelconque des revendications 6 à 8, dans lequel le second appareil mobile est configuré pour transférer le substrat à la température normale et à la pression normale dans la cavité de traitement plasma.

10. Dispositif selon l'une quelconque des revendications 1 à 9, dans lequel le dispositif comprend également une pompe à vide, et la pompe à vide est configurée pour évacuer les gaz de la seconde cavité de traitement après que le film de carbone sur la surface du substrat balayé a été nettoyé par le plasma d'oxygène.

11. Procédé d'inspection, appliqué à un dispositif d'inspection par faisceau d'électrons, dans lequel le dispositif d'inspection par faisceau d'électrons comprend une première cavité de traitement (101) et une seconde cavité de traitement (102), et le procédé comprend :
la formation d'un film de carbone sur une surface d'un substrat par dépôt physique en phase vapeur dans la première cavité de traitement ;
la réalisation, dans la seconde cavité de traitement, d'un balayage par faisceau d'électrons sur le substrat avec la surface sur laquelle le film de carbone est déposé ;
le procédé d'inspection étant **caractérisé en ce qu'**il comprend également l'étape suivante :
le nettoyage du film de carbone sur la surface du substrat balayé par plasma d'oxygène dans la seconde cavité de traitement.

12. Procédé selon la revendication 11, dans lequel l'épaisseur du film de carbone est inférieure à 10 nm.

13. Procédé selon la revendication 11 ou 12, dans lequel, avant la formation d'un film de carbone sur une surface du substrat par dépôt physique en phase vapeur dans la première cavité de traitement, le procédé comprend également :
le nettoyage d'un film organique sur la surface du substrat par plasma d'oxygène dans la seconde cavité de traitement.

14. Procédé selon l'une quelconque des revendications 11 à 13, dans lequel le dispositif d'inspection par faisceau d'électrons comprend également un premier appareil mobile (103), et le procédé comprend également :
le transfert du substrat entre la première cavité de traitement et la seconde cavité de traitement à travers le premier appareil mobile.

15. Procédé selon l'une quelconque des revendications 11 à 14, dans lequel le dispositif d'inspection par faisceau d'électrons comprend également un second appareil mobile (104), et le procédé comprend également :
le transfert du substrat à une température normale et à une pression normale vers la seconde cavité de traitement à travers le second appareil mobile.
